# EUROPEAN PATENT APPLICATION

(11) **EP 4 676 006 A1**
(43) Date of publication of application: **07.01.2026**
(21) Application number: 24186403.2
(22) Date of filing: 04.07.2024
(51) Int. Cl.: H04L 67/12, B60L 3/12

(54) **AN INTERACTIVE DIGITAL TWIN SYSTEM ONBOARD A VEHICLE**

(71) Applicant: VOLVO TRUCK CORPORATION, 405 08 Göteborg (SE)
(72) Inventor: Shah, Sanket, 560016 Bengaluru (IN); Ramkumar V, Chaithanya, 560087 Bangalore (IN)
(74) Representative: Valea AB

(57) **Abstract**

A method includes executing, by an Electronic Control Unit (ECU) of a vehicle, a physics-based simulation of a first simulated component of a plurality of simulated components of a digital twin including a plurality of corresponding simulated components, the first simulated component corresponding to a first physical component of a plurality of physical components of the vehicle. The method further includes modifying, by the ECU, a control strategy for operation of the vehicle to modify an operation of the vehicle based on the simulation of the first simulated component. The method further includes executing, by the ECU, the modified control strategy to control the first physical component. The third aspect of the disclosure may seek to improve operational efficiency for the vehicle.

## Description

### TECHNICAL FIELD

The disclosure relates generally to a digital twin system for a vehicle. In particular aspects, the disclosure relates to an interactive digital twin system onboard a vehicle, such as an electric vehicle. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

In many conventional vehicles, thermal and other component management controls are based on preexisting datasets that are derived by testing the vehicle under predefined test conditions. In addition to the cost and efforts associated with this testing, these tests cannot emulate all the scenarios that would be encountered in real world use. As a result, these preexisting datasets typically include large factors of safety to handle unexpected scenarios, which in turn may result in overdesigned components and overly conservative control strategies. There is a need for an improved system that allows for more efficient component design and control strategy to better utilize limited available resources.

### SUMMARY

According to a first aspect of the disclosure, a component management digital twin system for a vehicle includes a processor circuit and a memory. The memory includes a component management digital twin comprising a plurality of simulated components corresponding to a plurality of physical components of the vehicle, a control strategy for operation of the vehicle, and machine readable instructions. When executed by the processor circuit, the instructions cause the processor circuit to execute a physics-based simulation of a first simulated component of the plurality of simulated components of the digital twin, the first simulated component corresponding to a first physical component of the plurality of physical components of the vehicle. The instructions further cause the processor circuit to modify the control strategy to modify an operation of the vehicle based on the simulation of the first simulated component. The first aspect of the disclosure may seek to improve operational efficiency for the vehicle. A technical benefit may include optimizing operations and energy consumption to maximize efficiency and operational lifespan of the vehicle and vehicle components.

Optionally in some examples, including in at least one preferred example, the vehicle is an electric vehicle, the first physical component of the vehicle comprises an electrical component of the vehicle.

Optionally in some examples, including in at least one preferred example, the electrical component comprises an Energy Storage System (ESS).

Optionally in some examples, including in at least one preferred example, the ESS comprises a battery.

Optionally in some examples, including in at least one preferred example, the ESS comprises a fuel cell.

Optionally in some examples, including in at least one preferred example, the electrical component comprises an electric motor.

Optionally in some examples, including in at least one preferred example, the system further includes an Electronic Control Unit (ECU) for the vehicle, the ECU comprising the processor circuit and the memory.

Optionally in some examples, including in at least one preferred example, the modification the control strategy comprises modifying an operation strategy for the first physical component.

Optionally in some examples, including in at least one preferred example, the instructions further cause the processor circuit to execute the modified control strategy to control the first physical component.

Optionally in some examples, including in at least one preferred example, the instructions further cause the processor circuit to execute a physics-based simulation of a second simulated component of the plurality of simulated components of the digital twin, the second simulated component corresponding to a second physical component of the plurality of physical components of the vehicle. The modification the control strategy is further based on the simulation of the second simulated component.

Optionally in some examples, including in at least one preferred example, the modification the control strategy comprises modifying an operation strategy for the first physical component and the second physical component.

Optionally in some examples, including in at least one preferred example, the instructions further cause the processor circuit to execute the modified control strategy to control the first physical component and the second physical component.

Optionally in some examples, including in at least one preferred example, the instructions further cause the processor circuit to analyze the simulation of the first simulated component using at least one of artificial intelligence and/or machine learning techniques. The modification the control strategy is further based on the analysis of the simulation.

According to a second aspect of the disclosure, a vehicle includes a plurality of physical components and an Electronic Control Unit (ECU) including a processor circuit and a memory. The memory includes a component management digital twin comprising a plurality of simulated components corresponding to the plurality of physical components of the vehicle, a control strategy for operation of the vehicle, and machine readable instructions. When executed by the processor circuit, the instructions cause the processor circuit to execute a physics-based simulation of a first simulated component of the plurality of simulated components of the digital twin, the first simulated component corresponding to a first physical component of the plurality of physical components of the vehicle. The instructions further cause the processor circuit to modify the control strategy to modify an operation of the vehicle based on the simulation of the first simulated component. The second aspect of the disclosure may seek to improve operational efficiency for the vehicle. A technical benefit may include optimizing operations and energy consumption to maximize efficiency and operational lifespan of the vehicle and vehicle components.

Optionally in some examples, including in at least one preferred example, the vehicle is an electric vehicle, and the first physical component of the vehicle comprises an electrical component of the vehicle.

Optionally in some examples, including in at least one preferred example, the electrical component comprises an Energy Storage System (ESS).

Optionally in some examples, including in at least one preferred example, the electrical component comprises an electric motor.

Optionally in some examples, including in at least one preferred example, the modification the control strategy comprises modifying an operation strategy for the first physical component.

Optionally in some examples, including in at least one preferred example, the instructions further cause the processor circuit to execute the modified control strategy to control the first physical component.

According to a third aspect of the disclosure, a method includes executing, by an Electronic Control Unit (ECU) of a vehicle, a physics-based simulation of a first simulated component of a plurality of simulated components of a digital twin comprising a plurality of simulated components corresponding to a plurality of physical components of the vehicle, the first simulated component corresponding to a first physical component of a plurality of physical components of the vehicle. The method further includes modifying, by the ECU, a control strategy for operation of the vehicle to modify an operation of the vehicle based on the simulation of the first simulated component. The method further includes executing, by the ECU, the modified control strategy to control the first physical component. The third aspect of the disclosure may seek to improve operational efficiency for the vehicle. A technical benefit may include optimizing operations and energy consumption to maximize efficiency and operational lifespan of the vehicle and vehicle components.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
FIGS. 1A and 1B are an exemplary view of a component management digital twin stored onboard an Electronic Control Unit (ECU) of an electric vehicle, according to an example.
FIG. 2 is an exemplary view of an alternative component management digital twin, according to an example.
FIG. 3 is a flow chart of an exemplary method to modify a control strategy for a vehicle, according to an example
FIG. 4 is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure. According to some examples, a component management digital twin may be stored on an Electronic Control Unit (ECU) of a vehicle, along with a control strategy for operation of the vehicle.

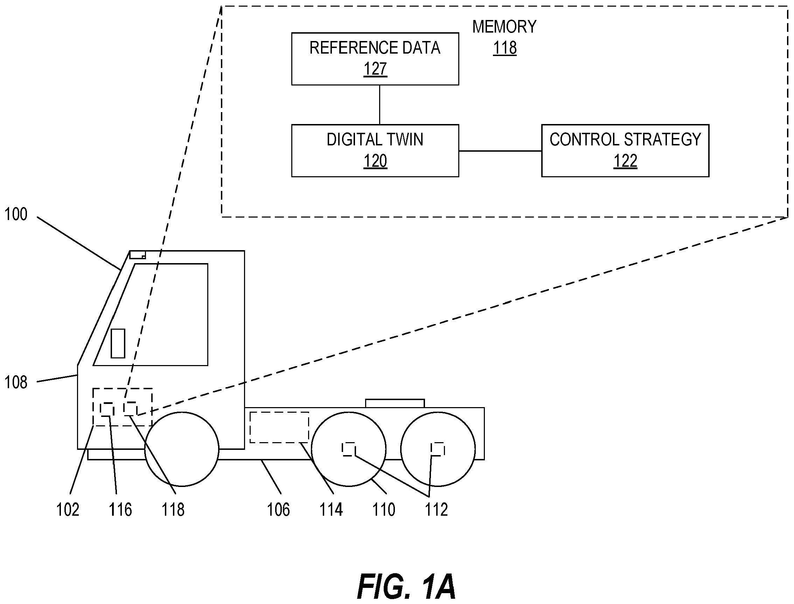

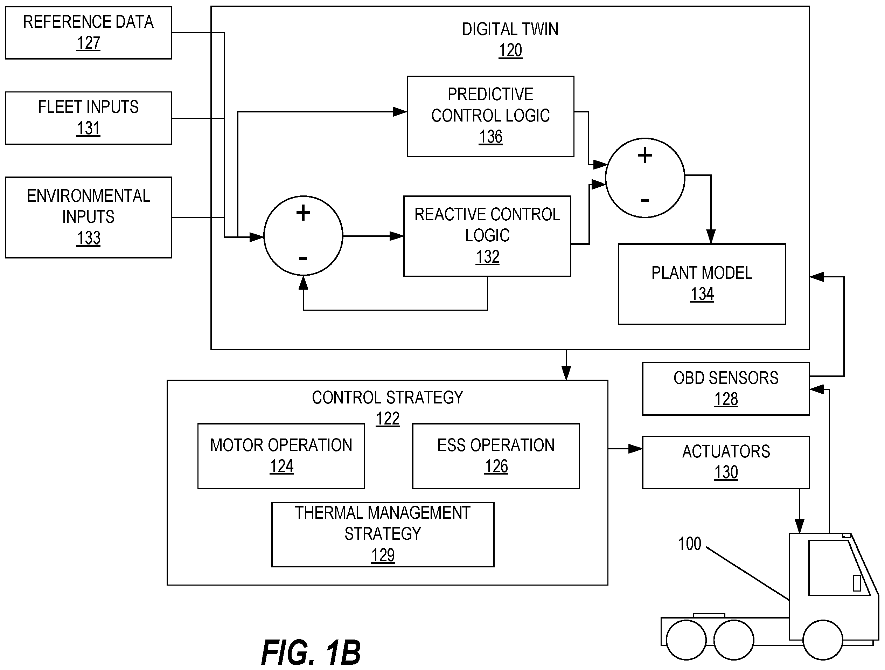

In this regard, FIGS. 1A and 1B are an exemplary view of a management digital twin 120 stored onboard an ECU 102 of an electric vehicle 100, according to an example. In this example, the vehicle 100 is a truck that includes a chassis 106, a cab 108, a plurality of wheels 110 driven by one or more electric motors 112, an energy storage system (ESS) 114 such as a battery or a fuel cell for example. The ECU 102 may include a processor circuit 116 and a memory 118 storing the component management digital twin 120 and a control strategy 122 for control of the vehicle 100.

The component management digital twin 120 in this example includes a plurality of simulated components, such as electrical components, which correspond to a plurality of physical components of the vehicle 100, such as the electric motor(s) 112, the ESS 114, thermal management components such as pumps, fans, valves, etc., and other components. When executed by the processor circuit 116 of the ECU 102, the ECU 102 executes a physics-based simulation of one or more simulated components of the digital twin 120. The simulation may include a thermal simulation and/or other type of simulation for various components, as desired. Based on the simulation, the ECU 102 modifies the control strategy 122 to modify an operation of the vehicle 100. For example, the control strategy 122 may include operation strategies for individual components, such as electric motor operation strategies 124, an ESS operation strategy 126, thermal management strategy 129, etc., and the modification of the control strategy 122 may likewise include modification of the individual operation strategies 124, 126, the modification of strategy for thermal management of components etc. Following modification of the control strategy 122, the ECU 102 may execute the modified control strategy 122 (e.g., one or more individual operations strategies 124, 126) to control the corresponding physical component(s) of the vehicle 100.

In some examples, the ECU 102 may analyze the simulation produced by the digital twin 120 using a number of analytical techniques, such as reinforcement learning techniques which is a subset of artificial intelligence and machine learning, to gain further insight into the operation (such as thermal operation) and condition of the components, and the modification of the control strategy 122 may be further based on the analysis of the simulation.

Technical advantages of this and other examples include the ability to conserve and optimize energy consumption by the vehicle 100, for example by deriving an optimal control strategy 122 for a selected route in real time based on predictions made by the digital twin 120. By managing the control strategy 122 for vehicle components, such amplitudes and duty cycles for motors 112, ESSs 114, control valves, pumps, fans, refrigerant compressor and other such thermal management components and other energy consuming components, improved efficiency can be achieved while reducing the need for added factors of safety that are used with conventional control strategies. The component management digital twin 120 may also be used to target predictive maintenance, route optimization, occupant comfort, peer to peer charging, and a number of additional functions associated with the vehicle 100, examples of which are discussed in detail below.

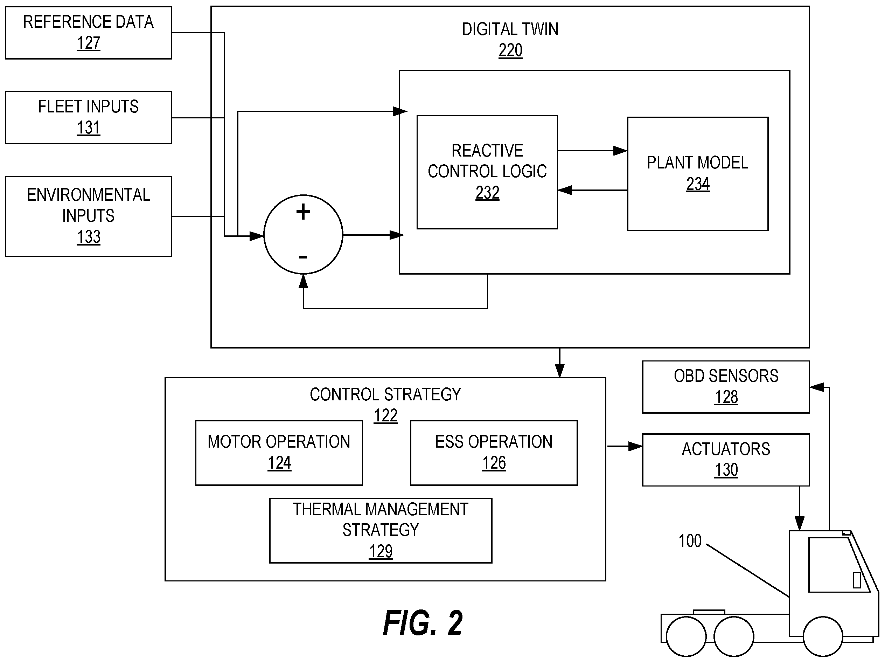

Unlike existing component management systems, which are based on pre-fed data sets (which require extensive testing) and control strategies (which are typically accompanied by a large factor of safety to handle worst-case scenarios), these and other examples allow for less overdesigned components and less conservative control strategies, thereby resulting in reduced energy consumption. For example, a conventional proportional, integral, and differential (PID) controller may use P, I, and D values for the control of pumps, compressors, heat rates, flow rates, etc., through extensive testing, such as in a testing grounds or on-road testing protocols. The component management digital twin 120 of FIGS. 1A and 2B, in contrast, may determine optimal P, I, and D values in real time and adapt these values based on a selected route. Unlike conventional PID controllers, the component management digital twin 120 may also use real time vehicle 100 data for predictive maintenance, which may predict service requirements of these components based on their current state, which can reduce the risk of failures and ceasing of operation of the vehicle 100.

As shown in FIGS. 1A and 1B, the digital twin 120 may receive input from a variety of sources, such as from reference data 127, the components themselves via On-Board Diagnostic (OBD) sensors 128 and/or actuators 130 associated with various components and/or from external sources such as fleet inputs 131 corresponding to data from other vehicles in a fleet, environmental inputs 133 corresponding to ambient conditions, live traffic, topography, and other information. In some examples, the external data may be provided periodically and/or in real time via a data and/or network connection accessible by the ECU 102. The digital twin 120 may provide the various inputs to a reactive control logic 132, which provides output data to both a physics-based plant model 134 for control of the vehicle 100 and recursively as a new input to the reactive control logic 132 for comparison with new real-world inputs to train and improve accuracy of subsequent output data. The input data may also be provided to a predictive control logic 136 which provides output data to the physics-based plant model 134 as well. Based on the output data received from the reactive control logic 132 and/or the predictive control logic 136, the plant model 134 may provide instructions to various components via one or more controllers 138 (such as thermal controllers, for example), which may directly or indirectly operate, activate, and or deactivate components based on thermal and/or other operational requirements. Unlike conventional route optimization tools, the component management digital twin 120 of FIGS. 1A and 1B is installed onboard the vehicle 100, such as in the ECU 102, and may run at 0.1-0.5x real time, i.e., using 0.1-0.5 seconds of computing time to run a simulation for 1 real-time second.

For example, for a route optimization operation, the digital twin may use some or all of the input data sources discussed above to run several iterations of the route with the fast-running plant model 134 within the digital twin 120 and arrive at an optimal control strategy for the driver. In some examples, the digital twin 120 may provide different strategies based on different criteria. For example, using minimum cost criteria, the digital twin 120 may propose a particular route, charging strategy and/or control strategy that takes into account the total energy consumed, charging costs, and the cost of the time taken to travel the route and turnaround time, and may propose a particular route, particular charging strategy, and particular control strategy to the driver. Other examples may include minimum energy consumption criteria for minimizing carbon output and increasing environmental sustainability, or minimum time criteria, for minimizing the total time of the route.

Information related to the selected strategy, such as route information, range, predicted cost, energy consumptions, and duration, may be displayed to the driver and may be updated in real time. In addition, the digital twin 120 may continue to optimize the route during the trip using real time sensor and other input data, and may further modify various strategies in real time. At the completion of the route, the actual values of electric range, energy consumed, trip duration, etc., may be determined and compared against the previously predicted values. The data, comparison, and/or calculated error may be provided to the digital twin 120 and/or uploaded as fleet data for future use by other vehicles. This comparison, the error and the data along with the trip control strategy are uploaded to the cloud for future use.

Output data may include driving scenarios such as the maximum speed and the best possible route based on the current state of charge of the vehicle's battery pack or the amount of fuel present, load in the vehicle, topography (gradient, number and angle of bends, etc.) of different possible routes, traffic, weather, etc. Other examples of output data may include air quality through a given route (e.g., by suggesting skipping a section of the route through an industrial/polluted area) which will impact cabin air quality and also the air quality for Fuel Cells, information regarding charging stations along a given route, the presence of a fleet of vehicles that are delivering nearby and ending their trip, which may be available to dispense some of their excess battery power to those vehicles that are low on battery power or charge.

As discussed above, the digital twin 120 may determine optimal P, I, and D values in real time and adapt these values based on a selected route. In some examples, different portions of the digital twin 120 (such as the predictive control logic 136, may use static (i.e., pre-fed) data while other components use dynamically generated data.

In this regard, FIG. 2 is an exemplary view of an alternative component management digital twin 220, according to an example. In this example, the reactive control logic 232 may include the plant model 234 and may directly control the vehicle components. That is, rather than feeding data for a predictive and reactive control logic to a controller, as in FIG. 1B, the reactive control logic 232 in this example may communicate with and control sensors 128, actuators 130, and other components directly.

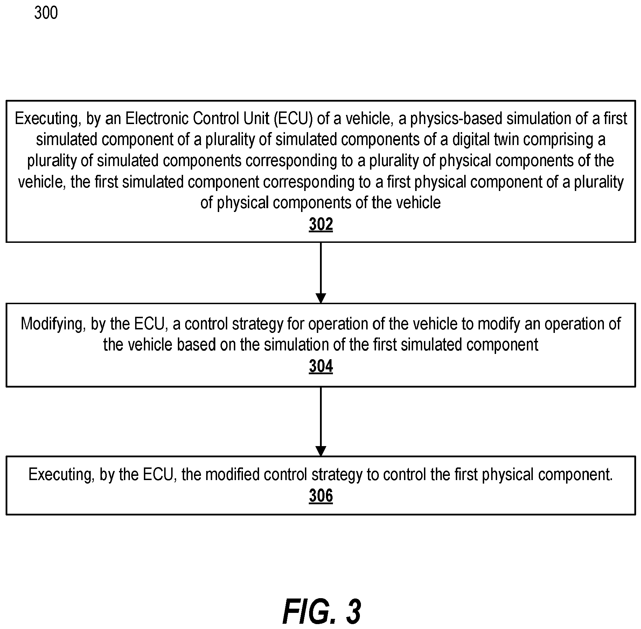

FIG. 3 is a flow chart of an exemplary method 300 to modify a control strategy for a vehicle, according to an example. The method 300 may include executing, by an Electronic Control Unit (ECU) of a vehicle, a physics-based simulation of a first simulated component of a plurality of simulated components of a digital twin comprising a plurality of simulated components corresponding to a plurality of physical components of the vehicle, the first simulated component corresponding to a first physical component of a plurality of physical components of the vehicle (Block 302). The method 300 may further include modifying, by the ECU, a control strategy for operation of the vehicle to modify an operation of the vehicle based on the simulation of the first simulated component (Block 304). The method may further include executing, by the ECU, the modified control strategy to control the first physical component (Block 306).

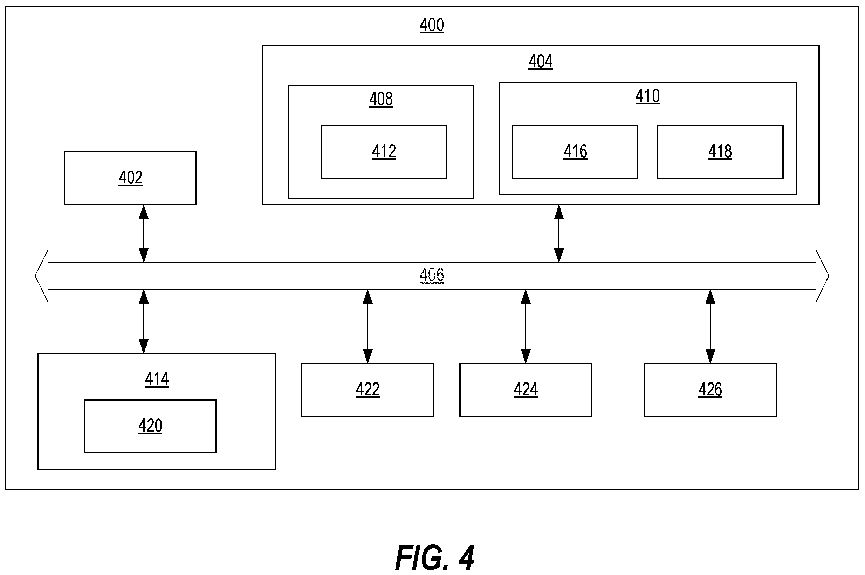

FIG. 4 is a schematic diagram of a computer system 400 for implementing examples disclosed herein. The computer system 400 is adapted to execute instructions from a computer-readable medium to perform these and/or any of the functions or processing described herein. The computer system 400 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 400 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 400 may comprise at least one computing device or electronic device capable of including firmware, hardware, and/or executing software instructions to implement the functionality described herein. The computer system 400 may include processing circuitry 402 (e.g., processing circuitry including one or more processor devices or control units), a memory 404, and a system bus 406. The computer system 400 may include at least one computing device having the processing circuitry 402. The system bus 406 provides an interface for system components including, but not limited to, the memory 404 and the processing circuitry 402. The processing circuitry 402 may include any number of hardware components for conducting data or signal processing or for executing computer code stored in memory 404. The processing circuitry 402 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 402 may further include computer executable code that controls operation of the programmable device.

The system bus 406 may be any of several types of bus structures that may further interconnect to a memory bus (with or without a memory controller), a peripheral bus, and/or a local bus using any of a variety of bus architectures. The memory 404 may be one or more devices for storing data and/or computer code for completing or facilitating methods described herein. The memory 404 may include database components, object code components, script components, or other types of information structure for supporting the various activities herein. Any distributed or local memory device may be utilized with the systems and methods of this description. The memory 404 may be communicably connected to the processing circuitry 402 (e.g., via a circuit or any other wired, wireless, or network connection) and may include computer code for executing one or more processes described herein. The memory 404 may include non-volatile memory 408 (e.g., read-only memory (ROM), erasable programmable read-only memory (EPROM), electrically erasable programmable read-only memory (EEPROM), etc.), and volatile memory 410 (e.g., random-access memory (RAM)), or any other medium which can be used to carry or store desired program code in the form of machine-executable instructions or data structures and which can be accessed by a computer or other machine with processing circuitry 402. A basic input/output system (BIOS) 412 may be stored in the non-volatile memory 408 and can include the basic routines that help to transfer information between elements within the computer system 400.

The computer system 400 may further include or be coupled to a non-transitory computer-readable storage medium such as the storage device 414, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 414 and other drives associated with computer-readable media and computer-usable media may provide non-volatile storage of data, data structures, computer-executable instructions, and the like. Computer-code which is hard or soft coded may be provided in the form of one or more modules. The module(s) can be implemented as software and/or hard coded in circuitry to implement the functionality described herein in whole or in part. The modules may be stored in the storage device 414 and/or in the volatile memory 410, which may include an operating system 416 and/or one or more program modules 418. All or a portion of the examples disclosed herein may be implemented as a computer program 420 stored on a transitory or non-transitory computer-usable or computer-readable storage medium (e.g., single medium or multiple media), such as the storage device 414, which includes complex programming instructions (e.g., complex computer-readable program code) to cause the processing circuitry 402 to carry out actions described herein. Thus, the computer-readable program code of the computer program 420 can comprise software instructions for implementing the functionality of the examples described herein when executed by the processing circuitry 402. In some examples, the storage device 414 may be a computer program product (e.g., readable storage medium) storing the computer program 420 thereon, where at least a portion of a computer program 420 may be loadable (e.g., into a processor) for implementing the functionality of the examples described herein when executed by the processing circuitry 402. The processing circuitry 402 may serve as a controller or control system for the computer system 400 that is to implement the functionality described herein.

The computer system 400 may include an input device interface 422 configured to receive input and selections to be communicated to the computer system 400 when executing instructions, such as from a keyboard, mouse, touch-sensitive surface, etc. Such input devices may be connected to the processing circuitry 402 through the input device interface 422 coupled to the system bus 406 but can be connected through other interfaces, such as a parallel port, an Institute of Electrical and Electronic Engineers (IEEE) 1394 serial port, a Universal Serial Bus (USB) port, an IR interface, and the like. The computer system 400 may include an output device interface 424 configured to forward output, such as to a display, a video display unit (e.g., a liquid crystal display (LCD) or a cathode ray tube (CRT)). The computer system 400 may include a communications interface 426 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

### Examples:

Example 1. A component management digital twin system for a vehicle comprising: a processor circuit; and a memory comprising: a component management digital twin comprising a plurality of simulated components corresponding to a plurality of physical components of the vehicle; a control strategy for operation of the vehicle; and
machine readable instructions that, when executed by the processor circuit, cause the processor circuit to: execute a physics-based simulation of a first simulated component of the plurality of simulated components of the digital twin, the first simulated component corresponding to a first physical component of the plurality of physical components of the vehicle; and modify the control strategy to modify an operation of the vehicle based on the simulation of the first simulated component.

Example 2. The component management digital twin system of example 1, wherein the vehicle is an electric vehicle, and wherein the first physical component of the vehicle comprises an electrical component of the vehicle.

Example 3. The component management digital twin system of example 2, wherein the electrical component comprises an Energy Storage System (ESS).

Example 4. The component management digital twin system of example 3, wherein the ESS comprises a battery.

Example 5. The component management digital twin system of example 3, wherein the ESS comprises a fuel cell.

Example 6. The component management digital twin system of example 2, wherein the electrical component comprises an electric motor.

Example 7. The component management digital twin system of example 1, further comprising an Electronic Control Unit (ECU) for the vehicle, the ECU comprising the processor circuit and the memory.

Example 8. The component management digital twin system of example 1, wherein the modification the control strategy comprises modifying an operation strategy for the first physical component.

Example 9. The component management digital twin system of example 1, wherein the instructions further cause the processor circuit to:
execute the modified control strategy to control the first physical component.

Example 10. The component management digital twin system of example 1, wherein the instructions further cause the processor circuit to: execute a physics-based simulation of a second simulated component of the plurality of simulated components of the digital twin, the second simulated component corresponding to a second physical component of the plurality of physical components of the vehicle, wherein the modification the control strategy is further based on the simulation of the second simulated component.

Example 11. The component management digital twin system of example 10, wherein the modification the control strategy comprises modifying an operation strategy for the first physical component and the second physical component.

Example 12. The component management digital twin system of example 10, wherein the instructions further cause the processor circuit to: execute the modified control strategy to control the first physical component and the second physical component.

Example 13. The component management digital twin system of example 1, wherein the instructions further cause the processor circuit to: analyze the simulation of the first simulated component using at least one of artificial intelligence and/or machine learning techniques, wherein the modification the control strategy is further based on the analysis of the simulation.

Example 14. A vehicle comprising: a plurality of physical components; an Electronic Control Unit (ECU) comprising: a processor circuit; and a memory comprising: a component management digital twin comprising a plurality of simulated components corresponding to the plurality of physical components of the vehicle; a control strategy for operation of the vehicle; and machine readable instructions that, when executed by the processor circuit, cause the processor circuit to: execute a physics-based simulation of a first simulated component of the plurality of simulated components of the digital twin, the first simulated component corresponding to a first physical component of the plurality of physical components of the vehicle; and modify the control strategy to modify an operation of the vehicle based on the simulation of the first simulated component.

Example 15. The vehicle of example 14, wherein the vehicle is an electric vehicle, and wherein the first physical component of the vehicle comprises an electrical component of the vehicle.

Example 16. The vehicle of example 15, wherein the electrical component comprises an Energy Storage System (ESS).

Example 17. The vehicle of example 15, wherein the electrical component comprises an electric motor.

Example 18. The vehicle of example 14, wherein the modification the control strategy comprises modifying an operation strategy for the first physical component.

Example 19. The vehicle of example 14, wherein the instructions further cause the processor circuit to: execute the modified control strategy to control the first physical component.

Example 20. A method comprising: executing, by an Electronic Control Unit (ECU) of a vehicle, a physics-based simulation of a first simulated component of a plurality of simulated components of a digital twin comprising a plurality of simulated components corresponding to a plurality of physical components of the vehicle, the first simulated component corresponding to a first physical component of a plurality of physical components of the vehicle; modifying, by the ECU, a control strategy for operation of the vehicle to modify an operation of the vehicle based on the simulation of the first simulated component; and executing, by the ECU, the modified control strategy to control the first physical component.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A component management digital twin system for a vehicle comprising:
a processor circuit; and
a memory comprising:
a component management digital twin comprising a plurality of simulated components corresponding to a plurality of physical components of the vehicle;
a control strategy for operation of the vehicle; and
machine readable instructions that, when executed by the processor circuit, cause the processor circuit to:
execute a physics-based simulation of a first simulated component of the plurality of simulated components of the digital twin, the first simulated component corresponding to a first physical component of the plurality of physical components of the vehicle; and
modify the control strategy to modify an operation of the vehicle based on the simulation of the first simulated component.

2. The component management digital twin system of claim 1, wherein the vehicle is an electric vehicle, and
wherein the first physical component of the vehicle comprises an electrical component of the vehicle.

3. The component management digital twin system of claim 2, wherein the electrical component comprises an Energy Storage System (ESS).

4. The component management digital twin system of claim 3, wherein the ESS comprises a battery.

5. The component management digital twin system of claim 3, wherein the ESS comprises a fuel cell.

6. The component management digital twin system of claim 2, wherein the electrical component comprises an electric motor.

7. The component management digital twin system of claim 1, further comprising an Electronic Control Unit (ECU) for the vehicle, the ECU comprising the processor circuit and the memory.

8. The component management digital twin system of claim 1, wherein the modification the control strategy comprises modifying an operation strategy for the first physical component.

9. The component management digital twin system of claim 1, wherein the instructions further cause the processor circuit to:
execute the modified control strategy to control the first physical component.

10. The component management digital twin system of claim 1, wherein the instructions further cause the processor circuit to:
execute a physics-based simulation of a second simulated component of the plurality of simulated components of the digital twin, the second simulated component corresponding to a second physical component of the plurality of physical components of the vehicle,
wherein the modification the control strategy is further based on the simulation of the second simulated component.

11. The component management digital twin system of claim 10, wherein the modification the control strategy comprises modifying an operation strategy for the first physical component and the second physical component.

12. The component management digital twin system of claim 10, wherein the instructions further cause the processor circuit to:
execute the modified control strategy to control the first physical component and the second physical component.

13. The component management digital twin system of claim 1, wherein the instructions further cause the processor circuit to:
analyze the simulation of the first simulated component using at least one of artificial intelligence and/or machine learning techniques,
wherein the modification the control strategy is further based on the analysis of the simulation.

14. A vehicle comprising:
a plurality of physical components;
an Electronic Control Unit (ECU) comprising:
a processor circuit; and
a memory comprising:
a component management digital twin comprising a plurality of simulated components corresponding to the plurality of physical components of the vehicle;
a control strategy for operation of the vehicle; and
machine readable instructions that, when executed by the processor circuit, cause the processor circuit to:
execute a physics-based simulation of a first simulated component of the plurality of simulated components of the digital twin, the first simulated component corresponding to a first physical component of the plurality of physical components of the vehicle; and
modify the control strategy to modify an operation of the vehicle based on the simulation of the first simulated component.

15. A method comprising:
executing, by an Electronic Control Unit (ECU) of a vehicle, a physics-based simulation of a first simulated component of a plurality of simulated components of a digital twin comprising a plurality of simulated components corresponding to a plurality of physical components of the vehicle, the first simulated component corresponding to a first physical component of a plurality of physical components of the vehicle;
modifying, by the ECU, a control strategy for operation of the vehicle to modify an operation of the vehicle based on the simulation of the first simulated component; and
executing, by the ECU, the modified control strategy to control the first physical component.
